# EUROPEAN PATENT APPLICATION

(11) **EP 0 948 047 A2**
(43) Date of publication of application: **06.10.1999**
(21) Application number: 98302097.5
(22) Date of filing: 20.03.1998
(51) Int. Cl.: H01L 23/36

(54) **Electronic component cooling arrangement**

(71) Applicant: Caesar Technology Inc., Chutung Town, Hsinchu Hsien (TW)
(72) Inventor: Chen, Kuo-Ming, Chutung Town, Hsinchu Hsien (TW)
(74) Representative: Selby-Lowndes, Guy Francis Charles

(57) **Abstract**

An electronic component cooling arrangement using a heat spreader covered on a part of a substrate over a chip for quick dissipation of heat from the chip. The heat spreader has a flat mounting section adhered to the substrate by silver epoxy to form a grounding loop, a main heat dissipating section disposed in contact with the chip, and a supporting frame section connected between the mounting section and the main heat dissipating section and adapted to support the main heat dissipating section at a higher elevation than the mounting section.

## Description

### BACKGROUND OF THE INVENTION

The present invention relates to an electronic component cooling arrangement, and more specifically to the cooling arrangement of a BGA (ball grid array) package.

An integrated circuit chip contains elements at a high density, its circuit arrangement is complicated, and its operation frequency is high. When a chip is in operation, it produces much heat. Heat from a chip may cause the circuit to be burned out, or cause a degradation to the circuit, and the reliability or life time of the chip will be greatly reduced or shortened. Therefore, providing cooling means to a chip to constrain the working temperature is important. However, because a chip is fragile, it is not easy to install cooling means in a chip. When installing cooling means in a chip, compatibility and inconvenience are main factors must be taken into account. The installation of cooling means must not cause a damage to the chip, reduce the yield, or increase much package cost. Further, the installation of cooling means complicates chip packaging procedure. In a BGA package, a substrate is provided having a chip carried on its top side, a plurality of welding balls provided at its bottom side, and a plurality of lead wires on its inside, The lead wires are respectively connected to top and bottom contacts of the substrate to electrically connect the chip to the welding balls. If the inductance of the lead wires is properly constrained, the conductivity of the package will be improved.

### SUMMARY OF THE INVENTION

The present invention has been accomplished under the circumstances in view. It is the main object of the present invention to provide a heat spreader for an electronic component cooling arrangement which is easy and inexpensive to manufacture, and which can be maintained in close contact with the chip for quick dissipation of heat without causing a damage to the chip. It is another object of the present invention to provide a heat spreader for an electronic component cooling arrangement which has a flat mounting section closely adhered to the chip carrier to form a grounding loop, so that the self-inductance of the lead wires of the chip carrier can be effectively constrained. It is still another object of the present invention to provide a heat spreader for an electronic component cooling arrangement which has a mounting section adhered to the chip carrier, a main heat dissipating section disposed in close contact with the chip for quick dissipation of heat, and a supporting frame section connected between the mounting section and the main heat dissipating section and defining a plurality of open spaces therebetween for easy application of a packing compound.

### BRIEF DESCRIPTION OF THE DRAWINGS

Fig. 1 is a sectional view of an electronic component cooling arrangement according to a first embodiment of the present invention;
Fig. 2 is a top view of a heat spreader for the electronic component cooling arrangement shown in Figure 1;
Fig. 3 is a top plain view in an enlarged scale of Figure 1, showing the earth contacts of the substrate electrically connected to the heat spreader;
Fig. 4 is a sectional view of an electronic component cooling arrangement according to a second embodiment of the present invention;
Fig. 5 is a sectional view of an electronic component cooling arrangement according to a third embodiment of the present invention;
Fig. 6 is a sectional view of a BGA package, showing the molded component covered over the whole area of the heat spreader according to the present invention; and
Fig. 7 is a sectional view of another BGA package, showing the molded component covered over a part of the heat spreader outside the main heat dissipating section according to the present invention.

### DETAILED DESCRIPTION OF THE PREFERRED EMBODIMENT

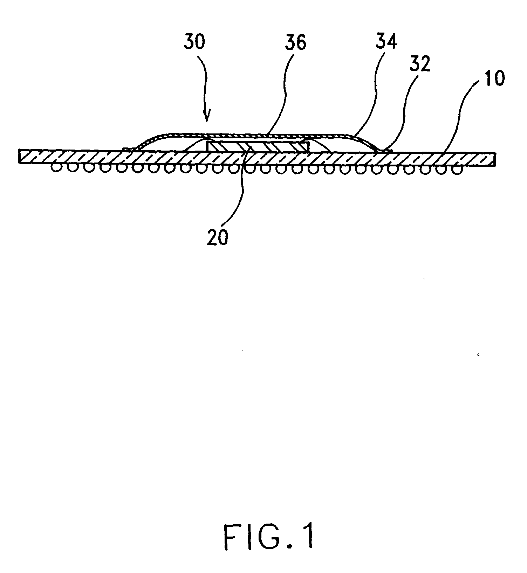

Referring to Figure 1, a chip **20** is carried on a substrate **10** BGA package, and a heat spreader **30** is covered on the chip **20** for quick dissipation of heat. The heat spreader **30** comprises a mounting section **32**, a supporting frame section **34**, and a main heat dissipating section **36**. The contact area between the mounting section **32** and the substrate **10** is covered with a layer of epoxy, and then a pressure is applied to the contact area to seal the mounting section **32** and the substrate **10** together. The main heat dissipating section **36** is connected to the mounting section **32** by the supporting frame section **34**. The main heat dissipating section **36** is supported on the supporting frame section **34** at a higher elevation than the mounting section **32**, such that the main heat dissipating section **36** is retained close to or in contact with the chip **20** without imparting a destructive downward pressure to the chip **20**. The supporting frame section **34** smoothly curves outwards. When the heat spreader **30** is installed, the mounting section **32** and the substrate **10** fit each other without leaving a gap therebetween. This arrangement greatly improves the electrical conductivity of the finished product.

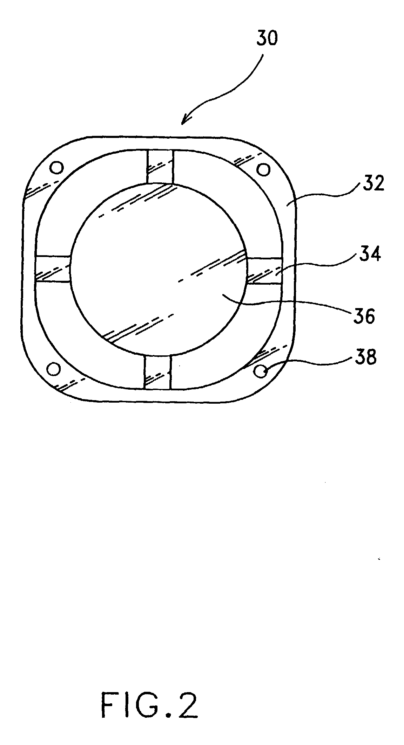

Referring to Figure 2 and Figure 1 again, the mounting section **32** of the heat spreader **30** preferably has a substantially annular shape, and is connected to the main heat dissipating section **36** by the supporting frame section **34**. Through holes **38** are provided at the mounting section **32**. The main heat dissipating section **36** and the mounting section **32** are disposed at different elevations. The supporting frame section **34** serves as buffer means between the main heat dissipating section **36** and the mounting section **32**.

The connection between the heat spreader **30** and the substrate **10** is achieved by applying an electrically conductive epoxy over a part of the substrate **10** corresponding to the bottom side of the mounting section **32** of the heat spreader **30**. Silver epoxy is an optimum choice for the electrically conductive epoxy. In order to save the epoxy, it can be allied to spot areas corresponding to the holes **38** of the mounting section **32** of the heat spreader **30**.

The supporting frame section **34** is connected between the mounting section **32** and the main heat dissipating section **36** with open spaces left therebetween. The open spaces in the supporting frame section **34** between the main heat dissipating section **36** and the mounting section **32** are adapted for the application of a packing compound.

The inner border side of the mounting section **32** form a boundary not continuously extended to the main heat dissipating section **36**. Therefore, when the heat spreader **30** is pressed on the substrate **10**, the electrically conductive epoxy is partially squeezed upwards along the inner boundary of the mounting section **32** without flowing to the bottom side of the main heat dissipating section **36** to destroy circuit insulation.

The heat spreader **30** is preferably made from aluminum. In order to provide a satisfactory insulative effect, the surface of the heat spreader **30** is preferably processed into a layer of aluminum oxide by anode oxidation method. Coating electrically insulative substance over the surface of the heat spreader **30** is another practical way. However, forming a layer of aluminum oxide over the surface of the heat spreader **30** enables the mounting section **32** of the heat spreader **30** to be positively sealed to the substrate **10** by an electrically conductive epoxy.

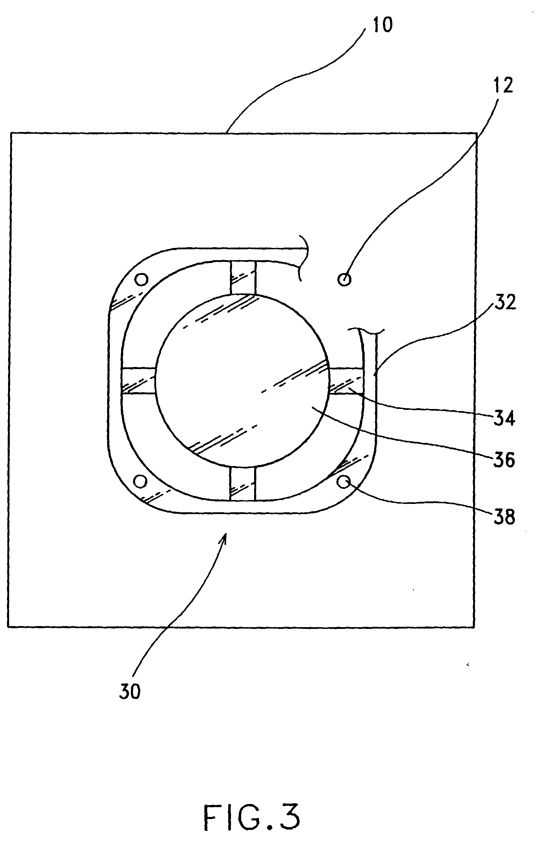

Referring to Figure 3 and Figure 1 again, the substrate **10** has a plurality of lead wires on the inside respectively connected to the chip **20** at the top side and the welding balls at the bottom side. A plurality of holes are provided at the top side of the substrate **10** through which earth contacts **12** are exposed to the outside. The earth contacts **12** are electrically connected to the mounting section **32** of the heat spreader **30** by the applied electrically conductive epoxy. Because the mounting section **32** is adhered to the surface of the substrate **10** and disposed close to the internal lead wires of the substrate **10**, the self-inductance of the lead wires of the substrate **10** is reduced.

The distance between the mounting section **32** of the heat spreader **30** and the lead wires of the substrate **10** affect the self-inductance of the lead wires of the substrate **10**. In order to achieve the optimum effect, the mounting section **32** of the heat spreader **30** is preferably closely attached to the surface of the substrate **10**. Further, the holes **38** of the mounting section **32** of the heat spreader **30** are disposed corresponding to the earth contacts **12** of the substrate **10**. When installed, the holes **38** of the mounting section **32** of the heat spreader **30** are filled up by the applied electrically conductive epoxy and connected to the earth contacts **12** of the substrate **10**, and therefore the heat spreader **30** and the substrate **10** are electrically connected to earth. The holes **38** are preferably made by punching after a layer of aluminum oxidation has been formed at the surface of the heat spreader **30**.

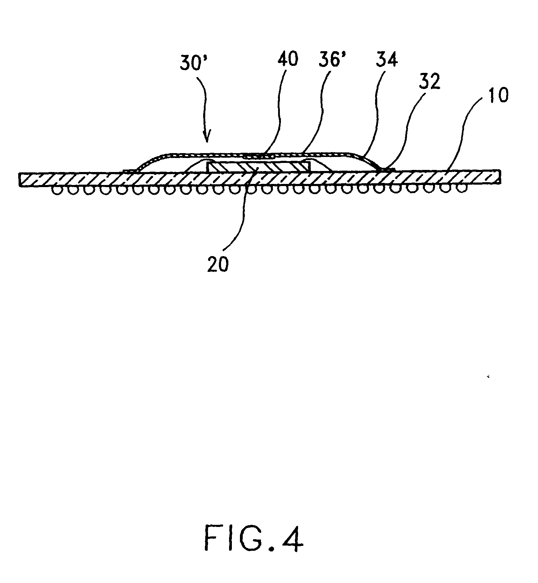

Figure 4 shows an alternate form of the present invention. The structure of the heat spreader **30'** according to this alternate form is similar to the heat spreader **30** shown in Figures from 1 to 3. However, the main heat dissipating section **36'** of this alternate form has a recessed portion **40** curved downwards for close contact with the chip **20**. The recessed portion **40** can be made by stamping. Alternatively, the main heat dissipating section **36'** can be made having a flat top side and a raised bottom side curved downwards for close contact with the chip **20**.

As before-stated, the supporting frame section **34** curves outwards to prevent a direct contact with the metal wires connected between the chip **20** and the substrate **10**. The thickness of the supporting frame section **34** is relatively thinner than the mounting section **32** and the main heat dissipating section **36**, therefore the supporting frame section **34** is forced to curve outwards when the heat spreader **30** is pressed on the substrate **10**.

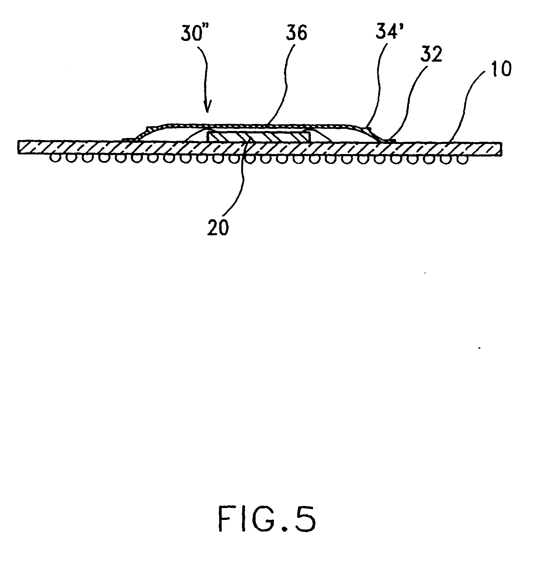

Figure 5 shows another alternate form of the present invention, in which the supporting frame section **34'** of the heat spreader **30''** has angled portions which force the supporting frame section **34'** to curve outwards when the heat spreader **30''** is pressed on the substrate **10**.

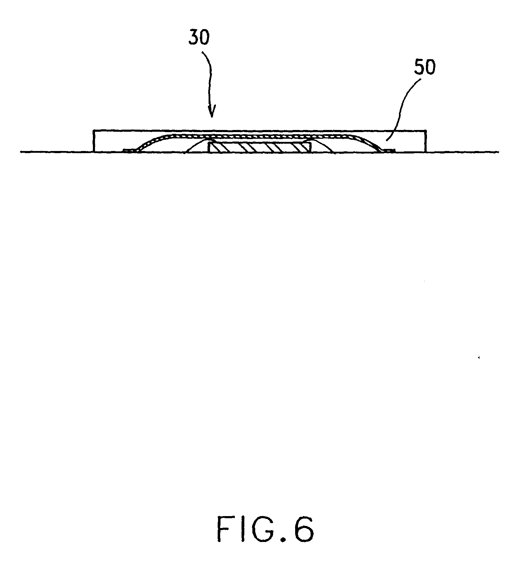

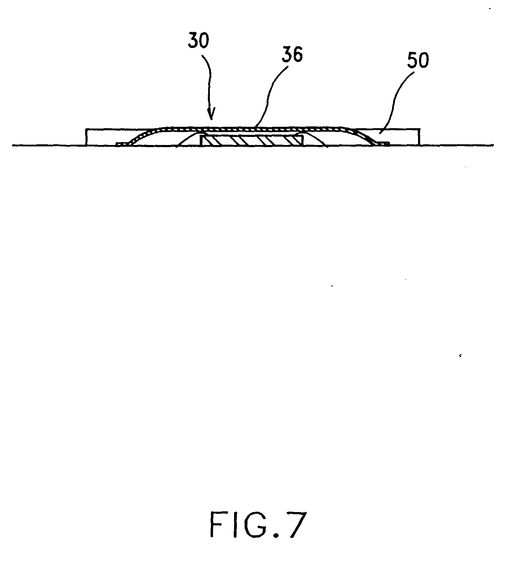

Figures 6 and 7 show an embedded type package and an exposed type package. In the embedded type package, the molded compound **50** covers the whole area of the heat spreader **30**. In the exposed type package, the molded compound **50** covers only a part of the heat spreader **30**, and the main heat dissipating section **36** of the heat spreader **30** is remained exposed to the outside for mounting an external heat dissipating apparatus. The compound **50** is selected from electrically insulative and water proof material, or preferably from epoxy resin.

It is to be understood that the drawings are designed for purposes of illustration only, and are not intended as a definition of the limits and scope of the invention disclosed.

## Claims

1. An electronic component cooling arrangement comprising:
a carrier means carrying a chip on a flat top side thereof, said carrier means having a plurality of earth contacts at its flat top side; and
a heat spreader covered on said chip and adapted to dissipate heat from said chip, said heat spreader comprising a mounting section disposed at a bottom side and having a flat bottom surface sealed to the flat top side of said carrier means, and a main heat dissipating section disposed at a top side in contact with said chip, said mounting section having a plurality of holes filled up with an electrically conductive epoxy and respectively fastened to the earth contacts of said carrier means.

2. The electronic component cooling arrangement of claim 1, wherein the mounting section of said heat spreader is adhered to said carrier means by an electrically conductive epoxy.

3. The electronic component cooling arrangement of claim 1, wherein said electrically conductive epoxy is silver epoxy.

4. The electronic component cooling arrangement of claim 2, wherein the electrically conductive epoxy which adheres the mounting section of said heat spreader and said carrier means together is silver epoxy.

5. The electronic component cooling apparatus of claim 1, wherein the main heat dissipating section of said heat spreader has a recessed portion formed by stamping and disposed in contact with said chip.

6. The electronic component cooling arrangement of claim 1, wherein the main heat dissipating section of said heat spreader has a raised bottom side disposed in contact with said chip.

7. The electronic component cooling arrangement of claim 1, wherein said heat spreader is made from aluminum.

8. The electronic component cooling arrangement of claim 6, wherein said heat spreader has an aluminum oxide outside surface formed by anode oxidation.

9. The electronic component cooling arrangement of claim 1, wherein said heat spreader further comprises a supporting frame section connected between said mounting section and said main heat dissipating section and adapted to support said main heat dissipating section above said mounting section.

10. The electronic component cooling arrangement of claim 9, wherein said supporting frame section curves outwards.

11. The electronic component cooling arrangement of claim 2, wherein said carrier means is a substrate for a ball grid array package.

12. The electronic component cooling arrangement of claim 1 further comprising a packing compound molded on said carrier means and covered over said heat spreader.

13. The electronic component cooling arrangement of claim 1 further comprising a packing compound molded on said carrier means and covered over said heat spreader outside said main heat dissipating section.

14. The electronic component cooling arrangement of claim 12, wherein said packing compound is epoxy resin.

15. The electronic component cooling arrangement of claim 13, wherein said packing compound is epoxy resin.
